Europäisches Patentamt

European Patent Office

Office européen des brevets

(19)

(11) Veröffentlichungsnummer: **0 309 713**
**A2**

## (12) EUROPÄISCHE PATENTANMELDUNG

(21) Anmeldenummer: 88113280.7

(22) Anmeldetag: 16.08.88

(51) Int. Cl.⁴: **H03H 9/02 , H03F 13/00**

(30) Priorität: 29.09.87 DE 3732857

(43) Veröffentlichungstag der Anmeldung:
05.04.89 Patentblatt 89/14

(84) Benannte Vertragsstaaten:
**DE FR GB NL**

(71) Anmelder: **Siemens Aktiengesellschaft Berlin und München**
**Wittelsbacherplatz 2**
**D-8000 München 2(DE)**

(72) Erfinder: **Schink, Helmut, Dr.**
**Barlowstrasse 7a**
**D-8000 München 81(DE)**
Erfinder: **Schnell, Ralf-Dieter, Dr.**
**Rieneckerstrasse 7**
**D-8000 München 60(DE)**

(54) **Verstärkender Oberflächenwellen-Empfänger.**

(57) Ein verstärkender Oberflächenwellen-Empfänger für ein Oberflächenwellen-Element aus einem Material, das den Piezoeffekt zeigt und durch lokale Dotierung elektrisch leitfähig gemacht werden kann, bei dem an der Oberseite eines das Oberflächenwellen-Element bildenden isolierenden Substratkörpers (8) aus dem charakterisierten Material ein Dotierungsgebiet ausgebildet ist, das einen leitfähigen Kanal (7) zwischen zumindest zwei einen bestimmten Abstand voneinander aufweisenden Kontaktelektroden (6, 6) derart bildet, daß auftretende Piezoladungen in der Lage sind, die Leitfähigkeit eines Kanals zu modulieren. An eine der Kontaktelektroden (6) ist ein Pol einer Spannungsquelle (4) angeschlossen, deren anderer Pol über einen Wechselstromdetektor (5) mit der anderen Kontaktelektrode (6) verbunden ist.

FIG 2

EP 0 309 713 A2

## Verstärkender Oberflächenwellen-Empfänger.

Die vorliegende Erfindung betrifft einen verstärkenden Oberflächenwellen-Empfänger für ein Oberflächenwellen-Element aus einem Material, das den Piezoeffekt und durch lokale Dotierung elektrisch leitfähig gemacht werden kann.

Bei Oberflächenwellen-Bauelementen werden die das Bauelement durchlaufenden Signale über Wandlerstrukturen ausgekoppelt. Diese Wandlerstrukturen bestehen im allgemeinen aus metallischen Bahnen, die auf einem isolierenden Substrat angeordnet sind. Über den Piezoeffekt koppelt die Oberflächenwelle Ladungen in den Körper des Oberflächenwellen-Bauelements ein, die als Signal abgegriffen werden können. Der Energieinhalt dieser Signale ist jedoch relativ klein, so daß das betreffende Signal nach dessen Auskopplung nachverstärkt und an entsprechende weiterverarbeitende elektronische Bauelemente angepaßt werden muß.

Der vorliegenden Erfindung liegt die Aufgabe zugrunde, einen verstärkenden Empfänger für Oberflächenwellen zu schaffen, mit dessen Hilfe in besonders einfacher Weise eine notwendige Verstärkung des das Oberflächenwellen-Bauelement durchlaufenden Signals erreicht werden kann.

Die der vorliegenden Erfindung zugrundeliegende Aufgabe wird durch einen verstärkenden Oberflächenwellen-Empfänger gelöst, der erfindungsgemäß durch die in dem kennzeichnenden Teil des Anspruchs 1 angegebenen Merkmale charakterisiert ist.

Vorteilhafte Weiterbildungen der Erfindung sind durch die in den Unteransprüchen angegebenen Merkmale gekennzeichnet.

Im folgenden wird die vorliegende Erfindung anhand mehrerer Figuren im einzelnen beschrieben.

Figur 1 zeigt eine schematische Darstellung eines piezoelektrischen Wandlers für Oberflächenwellen-Bauelemente auf einem isolierenden Substrat nach dem Stand der Technik.

Figur 2 zeigt eine schematische Darstellung eines bevorzugten Ausführungsbeispiels für einen Oberflächenwellen-Empfänger.

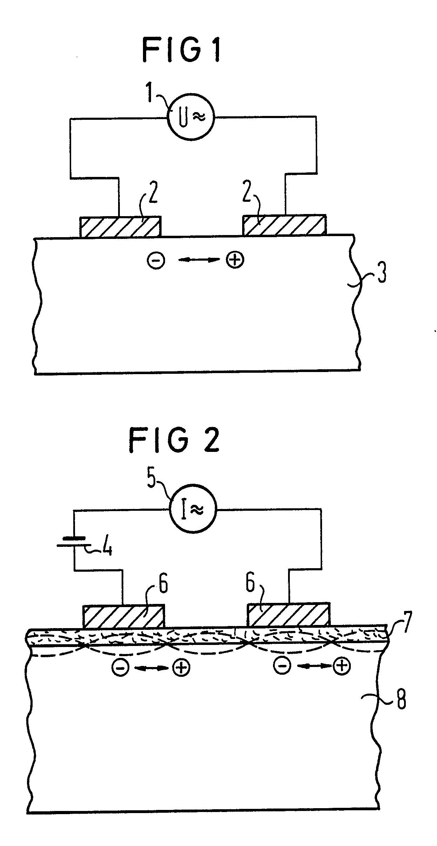

Figur 1 zeigt, wie bereits erläutert, einen piezoelektrischen Wandler nach dem Stand der Technik. Dieser bekannte piezoelektrische Wandler besteht aus einem Substratkörper 3 aus einem isolierenden Material, das den Piezoeffekt zeigt. Auf der Oberfläche dieses Substratkörpers 3 sind in einem vorbestimmten Abstand zwei metallische Kontaktelektroden 2, 2 aufgebracht, die jeweils mit einer Klemme eines Wechselspannungsdetektors 1 verbunden sind. Die Arbeitsweise einer derartigen Anordnung ist an sich bekannt, vergleiche beispielsweise IEEE 1982 ULTRA SONICS SYMPOSIUM, Seiten 456 bis 460, Michael J. Hoskins und Bill J. Hunsinger: "MONOLITHIC GaAs ACOUSTIC CHARGE TRANSPORT DEVICES".

Eine derartige bekannte Anordnung weist den Nachteil auf, daß die Größe der zur Verfügung stehenden Signalspannung an den beiden Kontaktelektroden 2, 2 aufgrund des geringen Energieinhalts der betreffenden Signale klein ist, so daß das Signal nach seiner Auskopplung nachverstärkt und an entsprechende weiterverarbeitende Einrichtungen angepaßt werden muß. Dies führt je nach Anwendungsfall gegebenenfalls zu Schwierigkeiten, in jedem Fall aber zu einem verhältnismäßig hohen technischen Aufwand.

Figur 2 zeigt, wie bereits erläutert, eine schematische Darstellung eines bevorzugten Ausführungsbeispiels für die vorliegende Erfindung. Die Darstellung zeigt einen verstärkenden Oberflächenwellen-Empfänger für ein Oberflächenwellen-Element aus einem Material, das den Piezoeffekt zeigt und durch lokale Dotierung elektrisch leitfähig gemacht werden kann. An der Oberseite eines das Oberflächenwellen-Element bildenden isolierenden Substratkörpers 8 aus dem zuvor charakterisierten Material ist ein Dotierungsgebiet ausgebildet, das einen leitfähigen Kanal 7 zwischen zwei einen bestimmten Abstand voneinander aufweisenden Kontaktelektroden 6, 6 derart bildet, daß auftretende Piezoladungen in der Lage sind, die Leitfähigkeit dieses Kanals 7 zu modulieren. An eine der Kontaktelektroden 6 ist ein Pol einer Spannungsquelle 4 angeschlossen, deren anderer Pol über einen Wechselstromdetektor 5 mit der anderen Kontaktelektrode 6 verbunden ist. Vorzugsweise ist das charakterisierte Material GaAs. Die Spannungsquelle 4 ist vorzugsweise eine Gleichspannungsquelle, kann jedoch alternativ dazu auch eine Wechselspannungsuqelle sein, deren Frequenz in einem vorgegebenen Verhältnis zu der Frequenz der Oberflächenwellen steht. Vorzugsweise bestehen die Kontaktelektroden 6, 6 aus einem metallischen Material, beispielsweise Aluminium. Der Wechselstromdetektor 5 kann in verschiedener Art und Weise ausgebildet sein. Vorzugsweise ist er als eine stromdetektierende Halbleiteranordnung ausgebildet, die als integraler Bestandteil des Oberflächenwellen-Elements auf dem Substratkörper 8 aufgebracht ist.

In die Darstellung gemäß Figur 2 ist schematisch in gestrichelten Linien die Veränderung des leitfähigen Kanals aufgrund der Steuerwirkung der auftretenden piezoelektrischen Ladungen eingetragen. Durch diese Veränderung oder Modulation des leitfähigen Kanals wird dessen Widerstand verändert, so daß sich in dem durch die Anordnung insgesamt gebildeten Stromkreis der Strom je nach Höhe der Spannung der Spannungsquelle 4 als welliger Gleichstrom oder als Wechselstrom darstellt, wobei dieser wellige Gleichstrom oder Wechselstrom in bekannter Weise durch den Wechselstromdetektor 5 erfaßt werden kann. Die Piezoladungen wirken ähnlich wie bei einem MESFET oder MOSFET die Gate-Ladungen. Die Verstärkungseigenschaften hängen dabei sowohl von der geometrischen als auch von der elektrischen Dimensionierung ab.

Das erfindungsgemäße Oberflächenwellenbauelement läßt sich auf allen Substrat-Materialien realisieren, die zum einen den Piezoeffekt zeigen und zum anderen durch lokale Dotierung elektrisch leitfähig gemacht werden können. Ein vorzugsweise zu verwendendes Material ist hierbei, wie bereits erwähnt, GaAs.

Die vorliegende Erfindung ist nicht auf das gezeigte Ausführungsbeispiel beschränkt. Modifikationen dieses Ausführungsbeispiels können durch den Fachmann ausgeführt werden, ohne daß dazu der allgemeine Erfindungsgedanke oder der Schutzumfang, wie er durch die Ansprüche bestimmt ist, verlassen werden müßte.

## Ansprüche

1. Verstärkender Oberflächenwellen-Empfänger für ein Oberflächenwellen-Element aus einem Material, das den Piezoeffekt zeigt und durch lokale Dotierung oder durch Aufbringung einer leitfähigen Schicht elektrisch leitfähig gemacht werden kann, dadurch **gekennzeichnet,** daß an der Oberseite eines das Oberflächenwellen-Element bildenden isolierenden Substratkörpers (8) aus dem charakterisierten Material ein gebiet ausgebildet ist, das einen leitfähigen Kanal (7) zwischen zumindest zwei einen bestimmten Abstand voneinander aufweisenden Kontaktelektroden (6, 6) derart bildet, daß auftretende Piezoladungen in der Lage sind, die Leitfähigkeit dieses Kanals (7) zu modulieren, und daß an eine der Kontaktelektroden (6) ein Pol einer Spannungsquelle (4) angeschlossen ist, deren anderer Pol über einen Wechselstromdetektor (5) mit der anderen Kontaktelektrode (6) verbunden ist.

2. Verstärkender Oberflächenwellen-Empfänger nach Anspruch 1, dadurch **gekennzeichnet,** daß das charakterisierte Material GaAs ist.

3. Verstärkender Oberflächenwellen-Empfänger nach Anspruch 1 oder 2, dadurch **gekennzeichnet,** daß die Kontaktelektroden (6, 6) aus einem metallischen Material bestehen.

4. Verstärkender Oberflächenwellen-Empfänger nach Anspruch 1 oder 2, dadurch **gekennzeichnet,** daß die Spannungsquelle (4) eine Gleichspannungsquelle ist.

5. Verstärkender Oberflächenwellen-Empfänger nach Anspruch 1 oder 2, dadurch **gekennzeichnet,** daß die Spannungsquelle (4) eine Wechselspannungsquelle ist, deren Frequenz in einem vorgegebenen Verhältnis zu der Frequenz der Oberflächenwellen steht.

6. Verstärkender Oberflächenwellen-Empfänger nach Anspruch 1 oder 2, dadurch **gekennzeichnet,** daß der Wechselstromdetektor (5) eine stromdetektierende Halbleiteranordnung ist, die als integraler Bestandteil des Oberflächenwellen-Elements auf den Substratkörper (8) aufgebracht ist.

# FIG 1

# FIG 2